# EUROPEAN PATENT SPECIFICATION

(11) **EP 1 662 582 B1**
(45) Date of publication and mention of the grant of the patent: **22.08.2018**
(21) Application number: 05257200.5
(22) Date of filing: 23.11.2005
(51) Int. Cl.: H01L 31/054, H02S 40/22

(54) **Solar cell module**
Solarzellenmodul
Module de cellules solaires

(30) Priority: 24.11.2004 JP 2004338613
(43) Date of publication of application: 31.05.2006
(73) Proprietor: Panasonic Intellectual Property Management Co., Ltd., Osaka-shi, Osaka 540-6207 (JP)
(72) Inventor: Baba, Toshiaki, Kobe-shi Hyogo 651-2242 (JP)
(74) Representative: Addiss, John William

(56) References cited:
- WO-A-99/09601
- WO-A-99/56317
- US-A- 4 235 643
- US-B1- 6 323 415

## Description

The present invention relates to a solar cell module, and more particularly, it relates to a solar cell module having a plurality of solar cells.

A solar cell module formed by arranging a plurality of solar cells on the surface of a glass plate at prescribed intervals while arranging light reflective members on regions corresponding to the spaces between the solar cells is known in general, as disclosed in Japanese Patent Laying-Open No. 11-298029 (1999), for example.

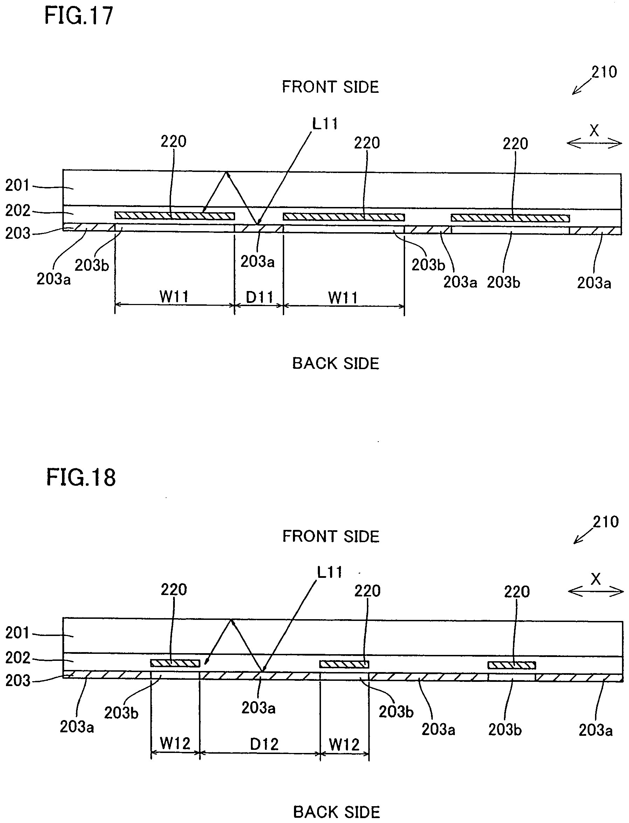

Fig. 17 is a sectional view showing the structure of a conventional solar cell module 210 formed by arranging light reflective members on regions corresponding to spaces between solar cells disclosed in the aforementioned Japanese Patent Laying-Open No. 11-298029. Referring to Fig. 17, a plurality of solar cells 220 are arranged on the back surface of a glass plate 201 through an EVA (ethylene vinyl acetate) layer 202 in the conventional solar cell module 210 formed by arranging light reflective members on regions corresponding to spaces between solar cells. A back sheet 203 of polyvinyl fluoride is arranged on regions of the plurality of solar cells 220 opposite to the glass plate 201 through the EVA layer 202. The EVA layer 202 also fills up the regions between the solar cells 220. Both of the refractive indices of the glass plate 201 and the EVA layer 202 are 1.5.

The back sheet 203 has white portions 203a painted white and uncolored transparent portions 203b. The white portions 203a of the back sheet 203 are arranged on regions corresponding to the spaces between the solar cells 220, while the transparent portions 203b of the back sheet 203 are arranged on regions corresponding to the locations of the solar cells 220. The white portions 203a of the back sheet 203 arranged on the regions corresponding to the spaces between the solar cells 220 function as light reflective members.

In the conventional solar cell module 210 shown in Fig. 17, light L11 incident upon the regions between the solar cells 220 from the front side at a prescribed angle is reflected by the white portions 203a of the back sheet 203 toward the glass plate 201 and thereafter reflected by the interface between the air and the glass plate 201, to be incident upon the solar cells 220. The light L11 passes through the interface between the glass plate 201 and the EVA layer 202 in an unrefracted state due to the same refractive indices (N = 1.5) of the glass plate 201 and the EVA layer 202. Thus, the conventional solar cell module 210 shown in Fig. 17 can introduce the light L11 incident upon the regions between the solar cells 220 into the solar cells 220 due to the light reflective members (white portions 203a of the back sheet 203) arranged between the solar cells 220.

If the area ratio of the solar cells 220 to the overall solar cell module 210 is reduced in order to reduce the cost for the solar cells 220 in the conventional solar cell module 210 formed by arranging the light reflective members (white portions 203a of the back sheet 203) on the regions corresponding to the spaces between the solar cells 220 disclosed in Japanese Patent Laying-Open No. 11-298029 shown in Fig. 17, however, the quantity of the light L11 incident upon the solar cells 220 is disadvantageously reduced. More specifically, the light L11 reflected by the white portions 203a of the back sheet 203 can be introduced into the solar cells 220 if the solar cells 220 have a width W11 in a direction X as shown in Fig. 17. If the width of the solar cells 220 in the direction X is reduced from W11 to W12 for increasing the interval between the solar cells 220 along the direction X from D11 to D12 as shown in Fig. 18, however, the light L11 reflected by the white portions 203a of the back sheet 203 does not reach the solar cells 220, to be reduced in quantity of incidence upon the solar cells 220. Thus, the quantity of the light L11 incident upon the solar cells 220 is disadvantageously reduced to reduce output characteristics if the area ratio of the solar cells 220 to the overall solar cell module 210 is reduced in order to reduce the cost for the solar cells 220 in the conventional solar cell module 210.

The document US6323415 discloses a solar module involving a back reflecting surface and two transparent members disposed on the solar cells. The present invention has been proposed in order to solve the aforementioned problem, and an object of the present invention is to provide a solar cell module capable of suppressing reduction of output characteristics by suppressing reduction of the quantity of light incident upon solar cells.

In order to attain the aforementioned object, a solar cell module according to claim 1 is proposed. In the solar cell module according to the invention, the light reflective member having the corrugated light reflective surface on the side closer to the first translucent member is arranged on the region of the surface of the first translucent member opposite to the incidence side corresponding to the space between the solar cells while the second translucent member having the refractive index higher than that of the first translucent member is embedded in at least the recess portions of the corrugated light reflective surface of the light reflective member, whereby light reflected by the light reflective surface toward the first translucent member is refracted on the interface between the first translucent member and the second translucent member having the refractive index higher than that of the first translucent member to increase an incident angle with reference to a direction perpendicular to the interface between the air and the first translucent member when incident upon this interface. Thus, an angle of reflection of the light with reference to the direction perpendicular to the interface between the air and the first translucent member is also increased, whereby the distance of movement of the light can be increased in a direction parallel to the surface of the first translucent member. Also when the interval between the plurality of solar cells arranged to hold the light reflective member therebetween is increased, therefore, the light reflected by the light reflective surface so easily reaches the solar cells that the quantity of the light incident upon the solar cells can be inhibited from reduction. Consequently, it is possible to suppress such a disadvantage that output characteristics are reduced due to reduction of the quantity of the light incident upon the solar cells also when the interval between the solar cells is increased by reducing the area ratio of the solar cells with respect to the overall solar cell module.

In the solar cell module according to an aspect of the invention, the first translucent member preferably includes at least either a glass plate or an ethylene vinyl acetate layer. According to this structure, it is possible to suppress such a disadvantage that output characteristics are reduced due to reduction of the quantity of the light incident upon the solar cells in the solar cell module having the solar cells arranged on the surface of at least the glass plate or the ethylene vinyl acetate layer. When the first translucent member includes both of the glass plate and the ethylene vinyl acetate layer, the glass plate and the solar cells can be bonded to each other through the ethylene vinyl acetate layer employed as a bonding member. When the first translucent member includes both of the glass plate and the ethylene vinyl acetate layer, refraction of light can be suppressed on the interface between the glass plate and the ethylene vinyl acetate layer, due to substantially identical refractive indices (1.5) of the glass plate and the ethylene vinyl acetate layer.

In this case, the first translucent member preferably includes both of the glass plate and the ethylene vinyl acetate layer. According to this structure, the glass plate and the solar cells can be easily bonded to each other through the ethylene vinyl acetate layer while suppressing refraction of light in the first translucent member (on the interface between the glass plate and the ethylene vinyl acetate layer).

In the aforementioned structure having the first translucent member including at least either the glass plate or the ethylene vinyl acetate layer, the second translucent member is preferably composed of at least one material selected from a group consisting of polycarbonate, polystyrene, polyphenyl methacrylate, polydiallyl phthalate, polypentachlorophenyl methacrylate, poly-o-chlorostyrene, polyvinyl naphthalene and polyvinyl carbazole. According to this structure, the refractive index of the second translucent member can be easily rendered higher than that of the first translucent member since the refractive indices of polycarbonate, polystyrene, polyphenyl methacrylate, polydiallyl phthalate, polypentachlorophenyl methacrylate, poly-o-chlorostyrene, polyvinyl naphthalene and polyvinyl carbazole are 1.6, 1.6, 1.57, 1.57, 1.61, 1.61, 1.68 and 1.68 respectively and the refractive indices of the glass plate and the ethylene vinyl acetate layer are 1.5.

In the aforementioned structure having the second translucent member composed of at least one material selected from the aforementioned group, the second translucent member is preferably composed of polycarbonate. When the second translucent member is composed of polycarbonate, the refractive index of the second translucent member can be easily rendered higher than that of the first translucent member.

In the solar cell module according to the aforementioned aspect, the first translucent member preferably includes either a glass plate or an ethylene vinyl acetate layer having a refractive index of about 1.5, and the second translucent member preferably has a refractive index higher than about 1.5 and not more than about 1.7. According to this structure, the interface between the first translucent member (the glass plate and the ethylene vinyl acetate layer) having the refractive index of about 1.5 and the second translucent member can be inhibited from increase of reflectance caused by the refractive index of the second translucent member higher than 1.7.

In the solar cell module according to the aforementioned aspect, the corrugated light reflective surface of the light reflective member is preferably formed to be inclined by a prescribed angle with respect to a direction parallel to the surface of the first translucent member and to extend in a direction substantially perpendicular to the direction of arrangement of the plurality of solar cells arranged at the prescribed interval. According to this structure, light reflected by the corrugated light reflective surface of the light reflective member can advance toward the side where the solar cells are arranged. Thus, the light reflected by the corrugated light reflective surface of the light reflective member can be easily introduced into the solar cells.

In the solar cell module according to the invention, each solar cell preferably has a plurality of slender finger electrodes arranged at a prescribed interval, and the plurality of slender finger electrodes are preferably arranged to extend in a direction substantially parallel to the traveling direction of light reflected by the corrugated light reflective surface of the light reflective member. According to this structure, the quantity of light blocked by the finger electrodes can be inhibited from increase when the light reflected by the light reflective surface is incident upon the solar cells. When the plurality of slender finger electrodes are arranged to extend in the direction perpendicular to the traveling direction of the light reflected by the light reflective surface, the virtual pitch (center distance) between the finger electrodes is reduced as viewed from the traveling direction (oblique direction) of the light incident upon the solar cells. Therefore, regions virtually formed with the finger electrodes are enlarged as viewed from the traveling direction of the light incident upon the solar cells, thereby reducing the quantity of light passing through the space between the finger electrodes. If the plurality of slender finger electrodes are arranged to extend in the direction substantially parallel to the traveling direction of the light reflected by the light reflective surface, therefore, the quantity of light blocked by the finger electrodes can be inhibited from increase when the light reflected by the light reflective surface is incident upon the solar cells as compared with a case of arranging the plurality of slender finger electrodes to extend in the direction perpendicular to the traveling direction of the light reflected by the light reflective surface.

In the solar cell module according to the aforementioned aspect, the second translucent member may be embedded in the recess portions of the corrugated light reflective surface of the light reflective member and formed to cover projecting portions of the corrugated light reflective surface of the light reflective member, and a surface of the second translucent member opposite to the light reflective member may be substantially flat. According to this structure, the second translucent member can be easily arranged on the surface of the first translucent member opposite to the incidence side by bonding the surface of the first translucent member opposite to the incidence side and the substantially flat surface of the second translucent member to each other.

In this case, the first translucent member preferably includes a face-side member and a bonding member for bonding the face-side member and the second translucent member to each other, the face-side member and the bonding member preferably have substantially identical refractive indices, and the substantially flat surface of the second translucent member is preferably bonded to the face-side member through the bonding member. According to this structure, the face-side member included in the first translucent member and the substantially flat surface of the second translucent member can be easily bonded to each other through the bonding member included in the first translucent member.

In the solar cell module according to the aforementioned aspect, a surface of the second translucent member opposite to the light reflective member may be in the form of a projecting arc. According to this structure, an incident angle with reference to a direction perpendicular to the interface between the first and second translucent members can be reduced when the light reflected by the light reflective surface passes through this interface, whereby the interface between the first and second translucent members can be inhibited from reflecting the light toward the light reflective member.

In this case, the first translucent member preferably includes a face-side member and a bonding member for bonding the face-side member and the second translucent member to each other, the face-side member and the bonding member preferably have substantially identical refractive indices, and the surface of the second translucent member in the form of a projecting arc is preferably bonded to the face-side member through the bonding member. According to this structure, the face-side member included in the first translucent member and the projecting arcuate surface of the second translucent member can be bonded to each other through the bonding member included in the first translucent member despite the surface of the second translucent member, provided in the form of the projecting arc, closer to the first translucent member (opposite to the light reflective member).

In the aforementioned structure having the first translucent member including the face-side member and the bonding member, the face-side member preferably includes a glass plate, and the bonding member preferably includes an ethylene vinyl acetate layer. According to this structure, the glass plate serving as the face-side member included in the first translucent member and the projecting arcuate surface of the second translucent member can be easily bonded to each other through the ethylene vinyl acetate layer serving as the bonding member included in the first translucent member.

In the aforementioned structure having the first translucent member including the face-side member and the bonding member, the bonding member preferably also has a function of bonding the face-side member and the solar cells to each other. According to this structure, no member may be separately provided for bonding the face-side member and the solar cells to each other.

In the solar cell module according to the aforementioned aspect, the second translucent member preferably includes a plurality of second translucent members embedded in the respective recess portions of the corrugated light reflective surface of the light reflective member. According to this structure, light reflected by the corrugated light reflective surface of the light reflective member can be substantially entirely introduced into the second translucent member.

In this case, a surface of each second translucent member opposite to the light reflective member is preferably in the form of a projecting arc. According to this structure, an incident angle with reference to a direction perpendicular to the interface between the first and second translucent members can be reduced when the light reflected by the light reflective surface passes through this interface, whereby the interface between the first and second translucent members can be inhibited from reflecting the light toward the light reflective member.

In the solar cell module according to the aforementioned aspect, a surface of the second translucent member opposite to the first translucent member is preferably corrugated, and a metal layer constituting the light reflective member is preferably formed on the corrugated surface of the second translucent member. According to this structure, the metal layer formed on the corrugated surface of the second translucent member is formed to have a corrugated shape reflecting the corrugated surface of the second translucent member, whereby the light reflective member can be easily formed with the corrugated light reflective surface.

In this case, the metal layer constituting the light reflective member is preferably formed to have a corrugated shape reflecting the corrugated surface of the second translucent member. According to this structure, the metal layer formed on the corrugated surface of the second translucent member can be easily employed as the light reflective member.

The foregoing and other objects, features, aspects and advantages of the present invention will become more apparent from the following detailed description of the present invention when taken in conjunction with the accompanying drawings.

### IN THE DRAWINGS:

Fig. 1 is a plan view showing the structure of a solar cell module according to an embodiment and Example 1 of the present invention;
Fig. 2 is a sectional view taken along the line 100-100 in Fig. 1;
Fig. 3 is a plan view of each solar cell constituting the solar cell module according to the embodiment and Example 1 shown in Fig. 1;
Fig. 4 is a sectional view taken along the line 200-200 in Fig. 3;
Fig. 5 is a plan view for illustrating a process of preparing a metal reflective film and a polycarbonate layer of the solar cell module according to the embodiment and Example 1 shown in Fig. 1;
Fig. 6 is a sectional view taken along the line 300-300 in Fig. 5;
Fig. 7 is a sectional view showing the structure of a solar cell modular according to comparative example;
Fig. 8 is a sectional view showing the structure of a reference solar cell module;
Fig. 9 is a graph showing the relation between the intervals between solar cells and normalized short-circuit currents;
Fig. 10 is an enlarged sectional view showing a light path in the solar cell module according to the embodiment and Example 1;
Fig. 11 is an enlarged sectional view showing a light path in the solar cell module according to comparative example;
Fig. 12 is a plan view showing the structure of a solar cell module according to Example 2 which is not part of the present invention;
Fig. 13 is a sectional view taken along the line 400-400 in Fig. 12;
Fig. 14 is a sectional view showing the structures of a metal reflective film and a polycarbonate layer of a solar cell module according to a first modification of the present invention;
Fig. 15 is a sectional view showing the structure of the solar cell module according to the first modification of the present invention;
Fig. 16 is a sectional view showing the structure of a solar cell module according to a second modification of the present invention;
Fig. 17 is a sectional view of a conventional solar cell module having light reflective members arranged on regions corresponding to spaces between solar cells; and
Fig. 18 is a sectional view for illustrating a problem of the conventional solar cell module.

An embodiment of the present invention is now specifically described.

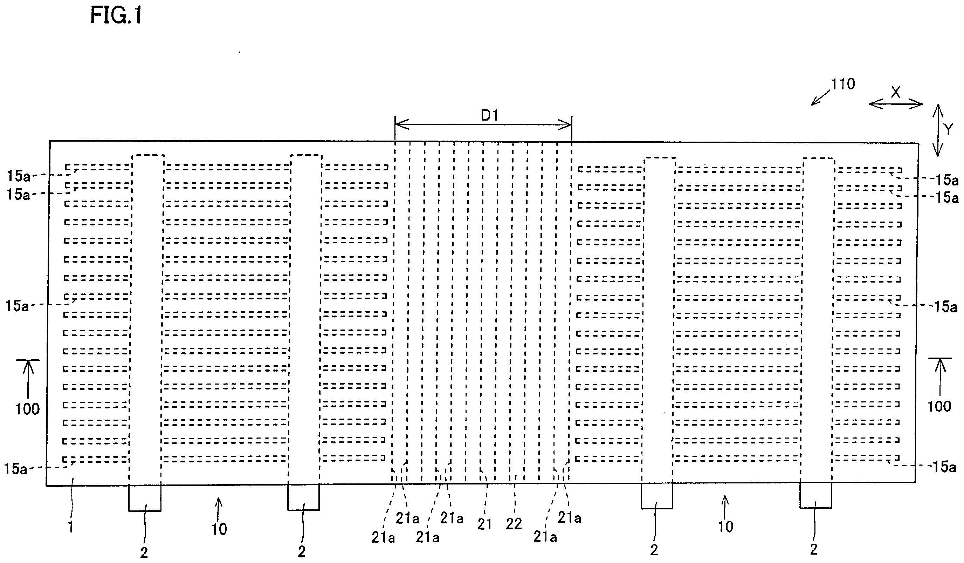

First, the structure of a solar cell module 110 according to the embodiment of the present invention is described with reference to Figs. 1 to 4.

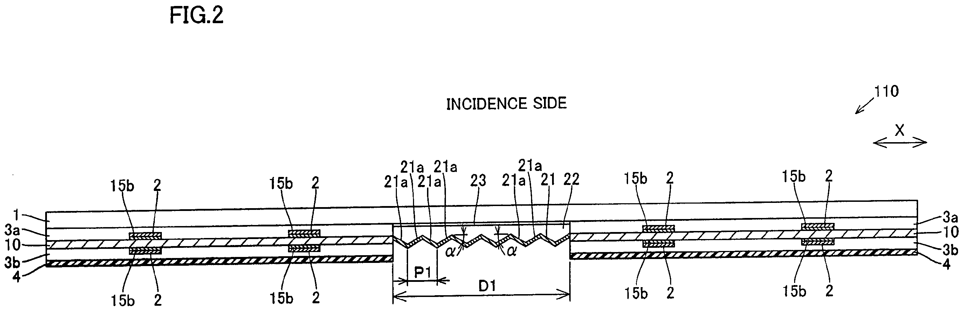

In the solar cell module 110 according to this embodiment, two solar cells 10 arranged at a prescribed interval D1 in a direction X and a metal reflective film 21 for reflecting light incident upon the region between the solar cells 10 and introducing the same into the solar cells 10 are provided on a surface of a glass plate 1, having a thickness of about 3 mm, opposite to an incidence side, as shown in Fig. 2. The glass plate 1 is an example of the "first translucent member" in the present invention, and the metal reflective film 21 is an example of the "light reflective member" or the "metal layer" in the present invention.

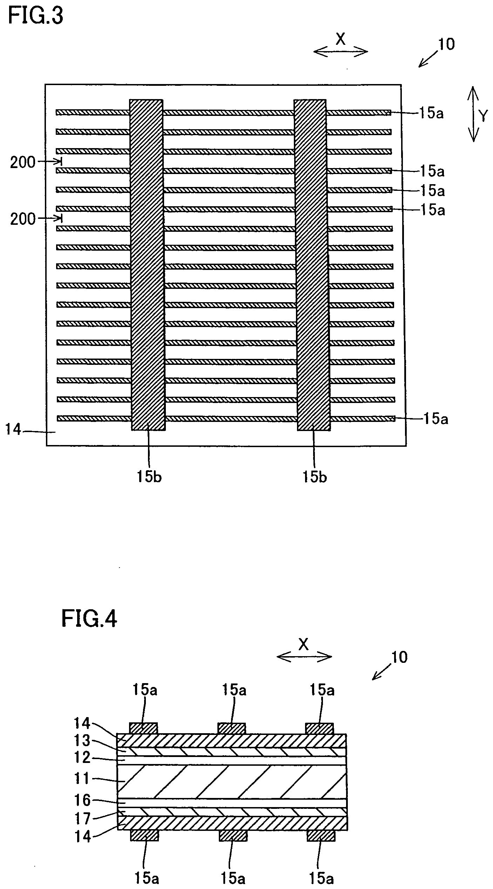

As shown in Fig. 4, a non-doped amorphous silicon layer 12 having a thickness of about 5 nm is formed on an n-type silicon substrate 11 of about 125 mm square having a thickness of about 200 µm with a surface of the (100) plane in each solar cell 10 according to this embodiment. The surface of the n-type silicon substrate 11 has a fine corrugated shape. A p-type amorphous silicon layer 13 having a thickness of about 5 nm is formed on the non-doped amorphous silicon layer 12. A transparent conductive film 14 of ITO (indium tin oxide) having a thickness of about 100 nm is formed on the p-type amorphous silicon layer 13. A plurality of finger electrodes 15a and two bus bar electrodes 15b (see Fig. 3) are formed on a prescribed region of the transparent conductive film 14. The finger electrodes 15a and the bus bar electrodes 15b are composed of Ag paste prepared by incorporating fine powder of Ag into epoxy resin. As shown in Fig. 3, the plurality of finger electrodes 15a are slenderly formed to extend in the direction X at a pitch (center distance) of about 2 mm. The two bus bar electrodes 15b are formed to extend in a direction Y perpendicular to the longitudinal direction of the finger electrodes 15a. The bus bar electrodes 15b have a shorter-side width of about 2 mm in the direction X. The finger electrodes 15a have a function of collecting currents, and the bus bar electrodes 15b have a function of aggregating the currents collected by the finger electrodes 15a.

As shown in Fig. 4, another non-doped amorphous silicon layer 16 having a thickness of about 30 nm is formed on the back surface of the n-type silicon substrate 11. An n-type amorphous silicon layer 17 having a thickness of about 30 nm is formed on the n-type amorphous silicon layer 16. Another transparent conductive film 14 of ITO having a thickness of about 100 nm is formed on the n-type amorphous silicon layer 17. Finger electrodes 15a and bus bar electrodes 15b (see Fig. 2) of a material (Ag paste), a center distance (about 2 mm) and a short-side width (about 2 mm) similar to those of the p-side finger electrodes 15a and the p-side bus bar electrodes 15b are formed on the n-side transparent conductive film 14.

As shown in Fig. 2, tab electrodes 2 are mounted on the bus bar electrodes 15b of the modularized solar cells 10 through solder layers (not shown). The tab electrodes 2 are composed of copper foil having a width of about 2 mm and a thickness of about 150 µm. As shown in Fig. 1, first ends of the tab electrodes 2 project outward from end surfaces of the solar cells 10.

As shown in Fig. 2, the p-sides of the solar cells 10 are arranged to face the surface of the glass plate 1 opposite to the incidence side through a translucent EVA (ethylene vinyl acetate) layer 3a having a thickness of about 1.5 mm. The EVA layer 3a is an example of the "first translucent member" in the present invention. On the other hand, the n-sides of the solar cells 10 are arranged to face a black film 4 of vinyl fluoride painted black through another translucent EVA layer 3b having a thickness of about 1.5 mm.

The metal reflective film 21 is formed by an Ag film having a thickness of about 0.3 µm, and has a corrugated light reflective surface 21a. The corrugated light reflective surface 21a is formed to extend in the direction Y (see Fig. 1) and inclined by about 30° (angle α) with respect to the direction parallel to the surface of the glass plate 1, as shown in Figs. 1 and 2. Thus, light perpendicularly incident upon the surface of the glass plate 1 closer to the incidence side and reflected by the corrugated light reflective surface 21a advances in the direction (X) perpendicular to the longitudinal direction (Y) of the corrugated light reflective surface 21a in plan view. The pitch PI (center distance) between recess portions of the corrugated light reflective surface 21a is about 4.17 mm, and the depth of the recess portions is about 1.2 mm.

According to this embodiment, the metal reflective film 21 is so arranged that the traveling direction (X) of the light reflected by the light reflective surface 21a and the longitudinal direction (X) of the slender finger electrodes 15a of the solar cells 10 are parallel to each other in plan view, as shown in Fig. 1. The metal reflective film 21 is arranged to extend in the direction Y (see Fig. 1) between the two solar cells 10 arranged at the prescribed interval D1.

According to this embodiment, a polycarbonate layer 22 is mounted on a surface portion of the glass plate 1 opposite to the incidence side and exposed between the two solar cells 10 arranged at the prescribed interval D1 through a standard refractive liquid 23 having a refractive index of 1.5. The polycarbonate layer 22 is an example of the "second translucent member" in the present invention. In this polycarbonate layer 22, the surface opposite to the glass plate 1 is corrugated while that closer to the glass plate 1 is flattened. The corrugated surface of the polycarbonate layer 22 is formed to extend in the direction Y (see Fig. 1) and inclined by about 30° (angle α) with respect to the surface of the glass plate 1. The corrugated surface of the polycarbonate layer 22 has a pitch of about 4.17 mm and a recess depth of about 1.2 mm. The aforementioned metal reflective film 21 of Ag having the thickness of about 0.3 µm is formed on the corrugated surface of the polycarbonate layer 22. The polycarbonate layer 22 has a refractive index (N = about 1.6) higher than the refractive indices (N = about 1.5) of the glass plate 1 and the EVA layer 3a.

According to this embodiment, as hereinabove described, the surface of the polycarbonate layer 22 closer to the glass plate 1 is so flattened that the polycarbonate layer 22 can be easily arranged on the surface of the glass plate 1 opposite to the incidence side by bonding the surface of the glass plate 1 opposite to the incidence side and the flat surface of the polycarbonate layer 22 to each other through the standard refractive liquid 23.

According to this embodiment, further, the surface of the polycarbonate layer 22 is corrugated and the metal reflective film 21 is formed on the corrugated surface of the polycarbonate layer 22 as hereinabove described so that the metal reflective film 21 formed on the corrugated surface of the polycarbonate layer 22 has a corrugated shape reflecting the corrugated surface of the polycarbonate layer 22, whereby the metal reflective film 21 having the corrugated light reflective surface 21a can be easily formed.

### (Example 1)

Example 1 of the present invention is now described with reference to actually prepared samples of the solar cell module 110 according to the aforementioned embodiment with reference to Figs. 1 to 6.

### [Preparation of Solar Cell Constituting Solar Cell Module]

First, an n-type silicon substrate 11 of 125 mm square having a thickness of 200 µm with a surface of the (100) plane was prepared as shown in Fig. 4. The surface of the n-type silicon substrate 11 was anisotropically etched with an NaOH aqueous solution. Thus, the n-type silicon substrate 11 had a fine corrugated surface. Thereafter impurities adhering to the surface of the n-type silicon substrate 11 were removed by cleaning this surface.

Then, a non-doped amorphous silicon layer 12 having a thickness of 5 nm and a p-type amorphous silicon layer 13 having a thickness of 5 nm were successively formed on the n-type silicon substrate 11 by high-frequency plasma CVD (chemical vapor deposition). Then, another non-doped amorphous silicon layer 16 having a thickness of 30 nm and an n-type amorphous silicon layer 17 having a thickness of 30 nm were successively formed on the back surface of the n-type silicon substrate 11 by high-frequency plasma CVD. Thereafter a transparent conductive film 14 of ITO having a thickness of 100 nm was formed on the p-type amorphous silicon layer 13 by sputtering, and another transparent conductive film 14 of ITO having a thickness of 100 nm was formed also on the n-type amorphous silicon layer 17.

Then, prescribed regions of the p- and n-side transparent conductive films 14 were printed with Ag paste prepared by incorporating fine powder of Ag into epoxy resin by screen printing, and the Ag paste was hardened under a temperature condition of 200°C thereby forming a plurality of finger electrodes 15a and two bus bar electrodes 15b (see Fig. 3). Thereafter the plurality of finger electrodes 15a were rendered slender and arranged to extend in a direction X at a pitch of 2 mm, as shown in Fig. 3. The two bus bar electrodes 15b were extended in a direction Y perpendicular to the longitudinal direction X of the finger electrodes 15a. The short-side width of the bus bar electrodes 15b along the direction X was set to 2 mm. Thus, each solar cell 10 was prepared for constituting the solar cell module 110 according to Example 1.

### [Preparation of Metal Reflective film and Polycarbonate Layer Constituting Solar Cell Module]

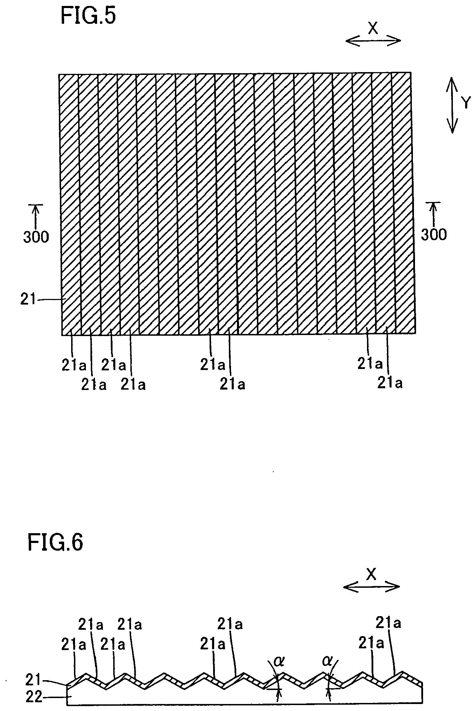

A translucent polycarbonate layer 22 having a corrugated surface was prepared as shown in Fig. 6. More specifically, the translucent polycarbonate layer 22 having a corrugated surface was formed by corrugating the surface of a plate material of transparent polycarbonate resin by roll forming. At this time, the surface of the polycarbonate layer 22 was so corrugated that recess portions thereof extended in the direction Y (see Fig. 1) at an inclination angle α of 30°. The recess portions of the surface of the polycarbonate layer 22 were set to a pitch of 4.17 mm and a depth of 1.2 mm. Only one surface of the polycarbonate layer 22 was corrugated in the aforementioned manner. In other words, the surface of the polycarbonate layer 22 opposite to the corrugated one was flattened.

Then, a metal reflective film 21 of Ag having a thickness of 0.3 µm was formed on the corrugated surface of the polycarbonate layer 22 by sputtering. At this time, the metal reflective film 21 was formed to have a corrugated shape reflecting the corrugated surface of the polycarbonate layer 22. In other words, the metal reflective film 21 was so formed that a corrugated light reflective surface 21a thereof extended in the direction Y at an inclination angle α of 30°, as shown in Figs. 5 and 6. Further, the metal reflective film 21 was so formed that recess portions of the corrugated light reflective surface 21a were at a pitch of 4.17 mm and a depth of 1.2 mm.

Then, the metal reflective film 21 and the polycarbonate layer 22 were so cut that the lengths in the direction (Y) parallel to the longitudinal direction Y of the corrugated light reflective surface 21a of the metal reflective film 21 were 125 mm. According to Example 1, five samples 1 to 5 were thereafter prepared with different lengths in the direction (X) perpendicular to the longitudinal direction Y of the corrugated light reflective surface 21a of the metal reflective film 21.

More specifically, the metal reflective film 21 and the polycarbonate layer 22 of the sample 1 were so cut that the lengths in the direction X were 8.3 mm.

The metal reflective film 21 and the polycarbonate layer 22 of the sample 2 were so cut that the lengths in the direction X were 16.7 mm.

The metal reflective film 21 and the polycarbonate layer 22 of the sample 3 were so cut that the lengths in the direction X were 25.0 mm.

The metal reflective film 21 and the polycarbonate layer 22 of the sample 4 were so cut that the lengths in the direction X were 33.3 mm.

The metal reflective film 21 and the polycarbonate layer 22 of the sample 4 were so cut that the lengths in the direction X were 41.7 mm.

### [Preparation of Solar Cell Module]

As shown in Figs. 1 and 2, tab electrodes 2 of copper foil having a width of 2 mm and a thickness of 150 µm were mounted on the bus bar electrodes 15b of the solar cells 10 through solder layers (not shown). At this time, first ends of the tab electrodes 2 projected outward from end surfaces of the solar cells 10, as shown in Fig. 1.

As shown in Fig. 2, a translucent EVA sheet having a thickness of 1.5 mm for forming an EVA layer 3a, the solar cells 10, another translucent EVA sheet for forming another EVA layer 3b and a black film 4 of vinyl fluoride painted black were successively stacked on a glass plate 1 having a thickness of 3 mm. At this time, the p-sides of the solar cells 10 were directed toward the glass plate 1. This laminate was thereafter heated under decompression at a temperature of 150°C, thereby bringing the surface of the glass plate 1 and the p-sides of the solar cells 10 into pressure contact with each other through the EVA sheet (EVA layer 3a) while bringing the n-sides of the solar cells 10 and the black film 4 into pressure contact with each other through the other EVA sheet (EVA layer 3b). The two solar cells 10 were arranged on the surface of the glass plate 1 at a prescribed interval D1 through the aforementioned pressure contact step. The side of the glass plate 1 mounted with no solar cells 10 defined the incidence side of the solar cell module 110. According to Example 1, the five samples 1 to 5 were prepared with different intervals D1 between the solar cells 10. More specifically, the intervals D1 between the pairs of solar cells 10 were set to 8.3 mm, 16.7 mm, 25.0 mm, 33.3 mm and 41.7 mm in the samples 1 to 5 respectively.

Then, a standard refractive liquid 23 was applied to the flat uncorrugated surface of the aforementioned polycarbonate layer 22. Thereafter the flat surface of the polycarbonate layer 22 was pressed against a surface portion of the glass plate 1 opposite to the incidence side and exposed between the solar cells 10, thereby bonding the flat surface of the polycarbonate layer 22 and the surface of the glass plate 1 opposite to the incidence side to each other. At this time, the polycarbonate layer 22 and the glass plate 1 were so bonded to each other as to parallelize the traveling direction (X) of light reflected by the light reflective surface 21a of the metal reflective film 21 and the longitudinal direction (X) of the slender finger electrodes 15a of the solar cells 10 in plan view, as shown in Fig. 1. According to Example 1, the polycarbonate layer 22 of each of the samples 1 to 5 was bonded to the surface portion of the glass plate 1 located between the solar cells 10 at the interval D1.

### (Comparative Example)

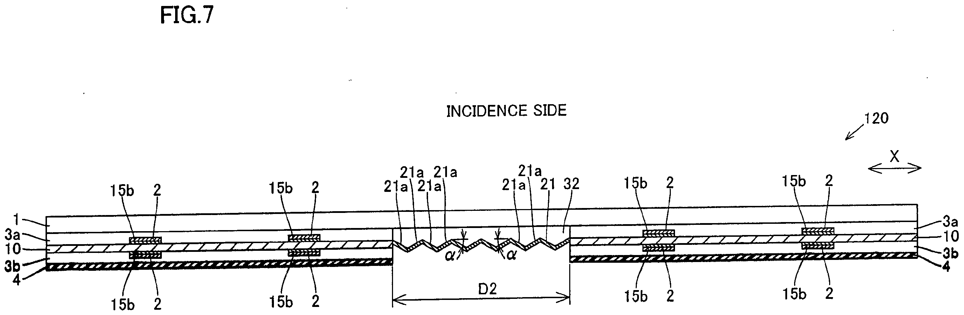

A process of preparing a solar cell module 120 according to comparative example is described with reference to Fig. 7. A step of preparing solar cells 10 constituting the comparative solar cell module 120 is similar to that of the aforementioned Example 1.

### [Preparation of Metal Reflective film and Acrylic Layer Constituting Solar Cell Module]

First, an acrylic layer 32 having a corrugated surface was prepared as shown in Fig. 7. More specifically, a translucent acrylic layer 32 having a corrugated surface was formed by corrugating the surface of a plate material of translucent acrylic resin by roll forming. At this time, the surface of the acrylic layer 32 was corrugated identically to the corrugated surface of the polycarbonate layer 2 of the aforementioned Example 1. The acrylic layer 32 had a refractive index of 1.5 identically to a glass plate 1 and an EVA layer 3a. Thereafter a metal reflective film 21 was formed on the corrugated surface of the acrylic layer 32 by sputtering with a composition and a thickness similar to those of the metal reflective film 21 of the aforementioned Example 1.

Then, the metal reflective film 21 and the acrylic layer 32 were so cut that the lengths in a direction (Y) parallel to the longitudinal direction Y of a corrugated light reflective surface 21a of the metal reflective film 21 were 125 mm. According to comparative example, five samples 6 to 10 were thereafter prepared with different lengths in a direction (X) perpendicular to the longitudinal direction Y of the corrugated light reflective surface 21a of the metal reflective film 21.

More specifically, the metal reflective film 21 and the acrylic layer 32 of the sample 6 were so cut that the lengths in the direction X were 8.3 mm.

The metal reflective film 21 and the acrylic layer 32 of the sample 7 were so cut that the lengths in the direction X were 16.7 mm.

The metal reflective film 21 and the acrylic layer 32 of the sample 8 were so cut that the lengths in the direction X were 25.0 mm.

The metal reflective film 21 and the acrylic layer 32 of the sample 9 were so cut that the lengths in the direction X were 33.3 mm.

The metal reflective film 21 and the acrylic layer 32 of the sample 10 were so cut that the lengths in the direction X were 41.7 mm.

### [Preparation of Solar Cell Module]

As shown in Fig. 7, two solar cells 10 were arranged on a surface of the glass plate 1 opposite to an incidence side at a prescribed interval D2 by a method similar to that in the aforementioned Example 1. At this time, the intervals D2 between the pairs of solar cells 10 were set to 8.3 mm, 16.7 mm, 25.0 mm, 33.3 mm and 41.7 mm in the samples 6 to 10 respectively, similarly to the aforementioned Example 1. Thereafter the acrylic layer 32 of each of the samples 6 to 10 was bonded to a surface portion of the glass plate 1 located between the solar cells 10 at the interval D2 in this comparative example by a method similar to that in the aforementioned Example 1. The remaining process of preparing the solar cell module 120 according to comparative example was similar to that of the aforementioned Example 1.

### (Common to Example 1 and Comparative Example)

### [Output Characteristic Experiment]

Then, short-circuit currents were measured as to the solar cell modules 110 and 120 according to Example 1 and comparative example prepared in the aforementioned manner.

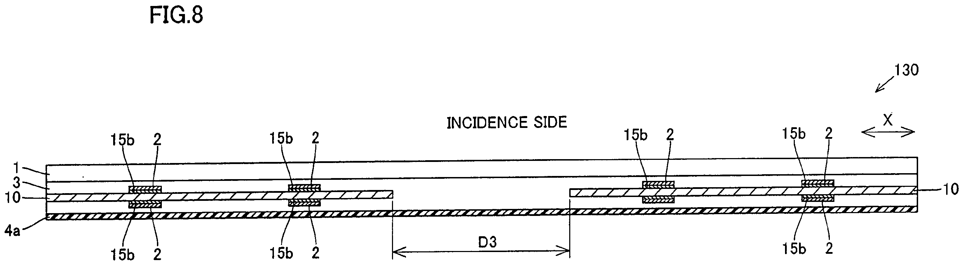

In this output characteristic experiment, a reference solar cell module 130 was prepared in a structure identical to those of the solar cell modules 110 and 120 shown in Figs. 2 and 7 respectively with no metal reflective film between solar cells 10, as shown in Fig. 8. More specifically, five samples of the reference solar cell module 130 were prepared with intervals D3 of 8.3 mm, 16.7 mm, 25.0 mm, 33.3 mm and 41.7 mm between pairs of solar cells 10, and the solar cells 10 and black films 4a were brought into pressure contact with each other through EVA sheets for forming EVA layers 3. Short-circuit currents were measured as to the five samples of the reference solar cell module 130 having the different intervals D3 between the pairs of solar cells 10 under pseudo-sunlight irradiation conditions of an optical spectrum of AM 1.5, light intensity of 0.1 W/cm² and a temperature of 25°C. The abbreviation AM (air mass) indicates the ratio of the path length of direct sunlight entering the earth's atmosphere to that in a case of perpendicularly entering the standard atmosphere (standard pressure: 1013 hPa).

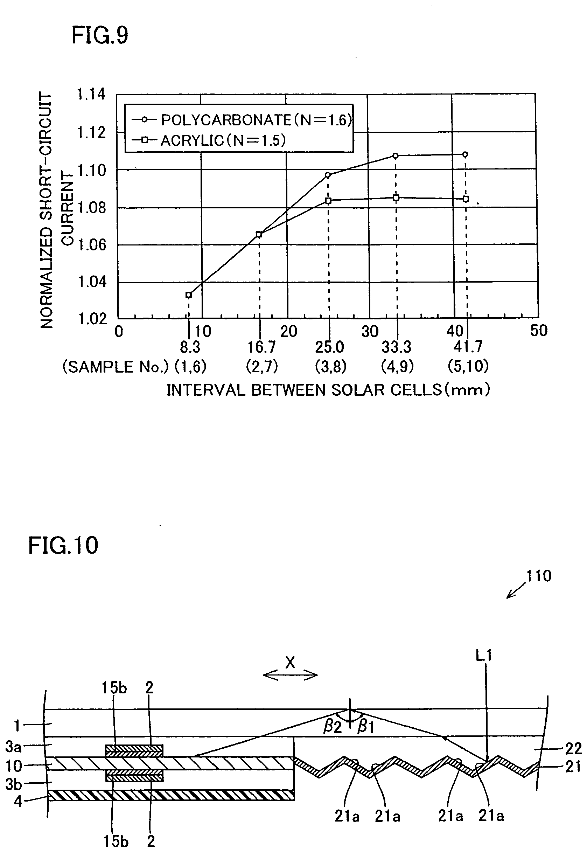

Thereafter the short-circuit currents were measured as to the solar cell module 110 (samples 1 to 5) according to Example 1 and the solar cell module 120 (samples 6 to 10) according to comparative example under the aforementioned conditions. Fig. 9 and Table 1 show the results. Normalized short-circuit currents of the samples 1 to 10 shown in Fig. 9 and Table 1 were normalized with reference to the short-circuit currents ("1") of the samples of the reference solar cell module 130 corresponding to the samples 1 to 10.

**Table 1**

| | SAMPLE No. | NORMALIZED SHORT-CIRCUIT CURRENT |
|---|---|---|
| EXAMPLE 1 | 1 | 1.033 |
| | 2 | 1.065 |
| | 3 | 1.097 |
| | 4 | 1.108 |
| | 5 | 1.108 |
| COMPARATIVE EXAMPLE | 6 | 1.033 |
| | 7 | 1.065 |
| | 8 | 1.084 |
| | 9 | 1.085 |
| | 10 | 1.084 |

Referring to Fig. 9 and Table 1, it has been proved that the solar cell module 110 according to Example 1 employing the polycarbonate layer 22 having the refractive index (N = 1.6) higher than the refractive indices (N = 1.5) of the glass plate 1 and the EVA layer 3a exhibits a short-circuit current higher than that of the solar cell module 120 according to comparative example employing the acrylic layer 32 having the refractive index (N = 1.5) identical to those of the glass plate 1 and the EVA layer 3a when the interval between the solar cells 10 exceeds 16.7 mm. More specifically, the samples 1 to 5 of the solar cell module 110 according to Example 1 having the intervals D1 of 8.3 mm, 16.7 mm, 25.0 mm, 33.3 mm and 41.7 mm between the solar cells 10 exhibited normalized short-circuit currents of 1.033, 1.065, 1.097, 1.108 and 1.108 respectively. The samples 6 to 10 of the solar cell module 120 according to comparative example having the intervals D2 of 8.3 mm, 16.7 mm, 25.0 mm, 33.3 mm and 41.7 mm between the solar cells 10 exhibited normalized short-circuit currents of 1.033, 1.065, 1.084, 1.085 and 1.084 respectively.

It is conceivable from these results that the quantity of light reflected by the metal reflective film 21 provided between the solar cells 10 and incident upon the solar cells 10 was larger in the solar cell module 110 according to Example 1 employing the polycarbonate layer 22 having the refractive index (N = 1.6) higher than those (N = 1.5) of the glass plate 1 and the EVA layer 3a than that of the solar cell module 120 according to comparative example employing the acrylic layer 32 having the same refractive index (N = 1.5) as those of the glass plate 1 and the EVA layer 3a when the interval between the solar cells 10 exceeded 16.7 mm. It is also conceivable that substantially 100 % of the light reflected by the metal reflective film 21 can be introduced into the solar cells 10 according to Example 1 when the interval D1 between the solar cells 10 is in the range up to 25.0 mm. On the other hand, it is conceivable that it is difficult to introduce substantially 100 % of light reflected by the metal reflective film 21 into the solar cells 10 according to comparative example when the interval D2 between the solar cells 10 exceeds 16.7 mm.

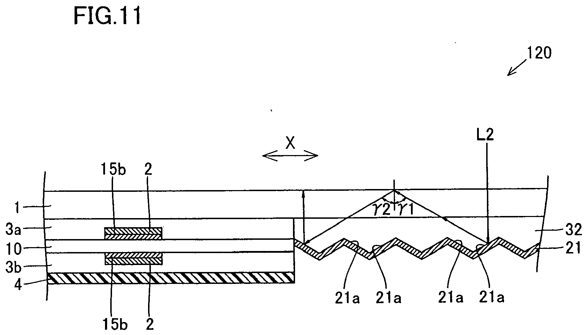

In the solar cell modules 110 and 120 according to Example 1 and comparative example, the light reflected by the metal reflective films 21 advances along paths shown in Figs. 10 and 11 respectively. More specifically, light L1 reflected by the metal reflective film 21 is refracted on the interface between the glass plate 1 and the polycarbonate layer 22 to increase an incident angle β1 with reference to a direction perpendicular to the interface between the air and the glass plate 1 when incident upon this interface due to the refractive index (N = 1.6) of the polycarbonate layer 22 higher than that (N = 1.5) of the glass plate 1 in the solar cell module 110 according to Example 1, as shown in Fig. 10. Thus, a reflection angle β2 of the light L1 on the interface between the air and the glass plate 1 with reference to the direction perpendicular to this interface is also increased, whereby the distance of movement of the light L1 is increased in the direction (X) perpendicular to the longitudinal direction (Y) of the corrugated light reflective surface 21a of the metal reflective film 21. Consequently, the quantity of the light L1 reflected by the metal reflective film 21 and incident upon the solar cells 10 was conceivably inhibited from reduction in the solar cell module 110 according to Example 1.

In the solar cell module 120 according to comparative example, on the other hand, light L2 reflected by the metal reflective film 21 is not refracted on the interface between the glass plate 1 and the acrylic layer 32 due to the same refractive indices (N = 1.5) of the glass plate 1 and the acrylic layer 32, as shown in Fig. 11. In other words, the light L2 is not so refracted as to increase an incident angle γ1 with reference to a direction perpendicular to the interface between the air and the glass plate 1 when incident upon this interface, dissimilarly to the solar cell module 110 according to Example 1 employing the aforementioned polycarbonate layer 22. Thus, a reflection angle γ2 of the light L2 on the interface between the air and the glass plate 1 with reference to the direction perpendicular to this interface is not increased either, whereby the distance of movement of the light L2 is reduced in the direction (X) perpendicular to the longitudinal direction Y of the corrugated light reflective surface 21a of the metal reflective film 21 as compared with the solar cell module 110 according to Example 1 employing the aforementioned polycarbonate layer 22. In this case, the light L2 is reintroduced into and reflected by the metal reflective film 21, and returned outward through the glass plate 1. Consequently, the quantity of the light L2 reflected by the metal reflective film 21 and incident upon the solar cells 10 was conceivably reduced in the solar cell module 120 according to comparative example when the interval D2 between the solar cells 10 exceeded 16.7 mm.

According to Example 1, as hereinabove described, the distance of movement of light can be increased in the direction X perpendicular to the longitudinal direction Y of the corrugated light reflective surface 21a of the metal reflective film 21 by corrugating the surface of the polycarbonate layer 22 having the refractive index (N = 1.6) higher than that (N = 1.5) of the glass plate 1 while forming the metal reflective film 21 on the corrugated surface of the polycarbonate layer 22 and bonding the flat surface of the polycarbonate layer 22 to the surface portion of the glass plate 1 opposite to the incidence side and exposed between the solar cells 10. Thus, light reflected by the light reflective surface 21a so easily reaches the solar cells 10 that the quantity of light incident upon the solar cells 10 can be inhibited from reduction also when the interval D1 between the solar cells 10 arranged to hold the metal reflective film 21 therebetween is increased. Consequently, it is possible to suppress such inconvenience that output characteristics are reduced due to reduction of the quantity of light incident upon the solar cells 10 also when the interval D1 between the solar cells 10 is increased by reducing the area ratio of the solar cells 10 with respect to the overall solar cell module 110 in order to reduce the cost for the solar cells 10.

According to Example 1, further, the quantity of light blocked by the finger electrodes 15a can be inhibited from increase when the light reflected by the light reflective surface 21a is incident upon the solar cells 10 as compared with a case of arranging the plurality of slender finger electrodes 15a to extend in the direction (Y) perpendicular to the traveling direction (X) of the light reflected by the light reflective surface 21a, by arranging the plurality of slender finger electrodes 15a to extend in the direction (X) parallel to the traveling direction (X) of the light reflected by the light reflective surface 21a.

### (Example 2)

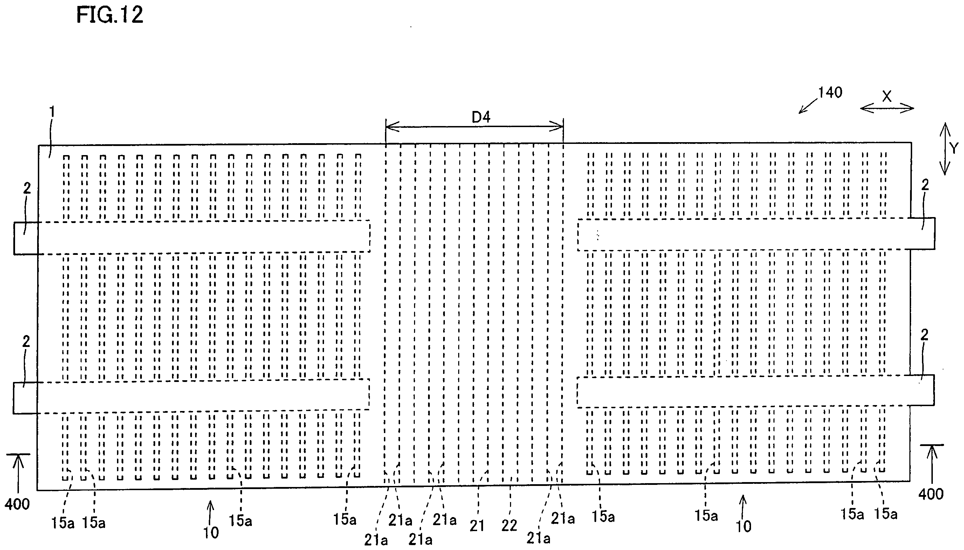

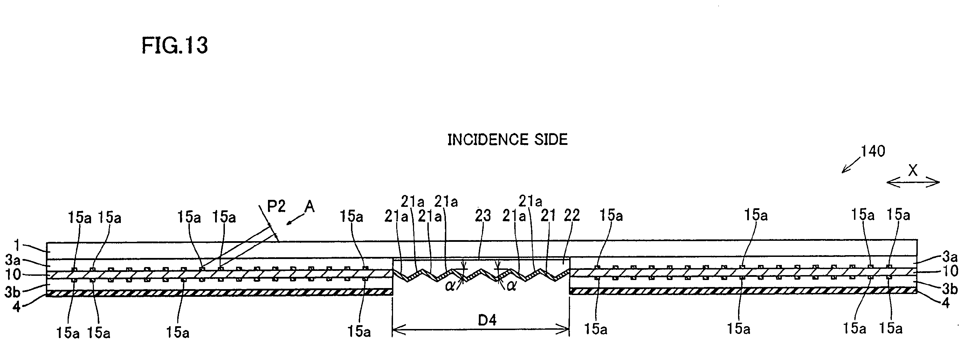

Referring to Figs. 12 and 13, a solar cell module 140 according to Example 2 which is not part of the present invention was prepared by arranging a plurality of slender finger electrodes 15a of solar cells 10 to extend in a direction perpendicular to a traveling direction (X) of light reflected by a light reflective surface 21a in a structure similar to that of the aforementioned Example 1. The remaining structure of the solar cell module 140 according to Example 2 is similar to that of the aforementioned Example 1.

A process of preparing the aforementioned solar cell module 140 according to Example 2 in practice is now described. Steps of preparing the solar cells 10, a metal reflective film 21 and a polycarbonate layer 22 constituting the solar cell module 140 according to Example 2 are similar to those in the aforementioned Example 1.

### [Preparation of Solar Cell Module]

As shown in Figs. 12 and 13, two solar cells 10 were arranged on a surface of a glass plate 1 opposite to an incidence side and the polycarbonate layer 22 was arranged on a surface portion of the glass plate 1 opposite to the incidence side and exposed between the solar cells 10 through a method similar to that in the aforementioned Example 1. According to Example 2, however, the slender finger electrodes 15a were arranged to extend perpendicularly to the traveling direction (X) of light reflected by the light reflective surface 21a of the metal reflective film 21. According to Example 2, further, the interval D4 between the solar cells 10 was set to 25.0 mm, and the polycarbonate layer 22 corresponded to that of the sample 3 (having the length of 25.0 mm in the direction X) of the aforementioned Example 2. The remaining process of preparing the solar cell module 140 according to Example 2 is similar to that of the aforementioned Example 2.

### [Output Characteristic Experiment]

Then, the short-circuit current was measured as to the solar cell module 140 according to Example 2 prepared in the aforementioned manner. This output characteristic experiment was carried out under conditions similar to those in the aforementioned output characteristic experiment for Example 1 and comparative example.

It has been proved that the short-circuit current of the solar cell module 140 according to Example 2 was higher than that of the sample 8 of the solar cell module 120 according to comparative example having the same interval D2 (25.0 mm) between the solar cells 10 as that in Example 2. More specifically, the solar cell module 140 according to Example 2 exhibited a normalized short-circuit current of 1.092, while the sample 8 of the solar cell module 120 according to comparative example exhibited the normalized short-circuit current of 1.084, as shown in Table 1. Thus, the quantity of light reflected by the metal reflective film 21 between the solar cells 10 and incident upon the solar cells 10 was conceivably increased as compared with that in the solar cell module 120 according to comparative example employing the acrylic layer 32 having the same refractive index (N = 1.5) as those of the glass plate 1 and the EVA layer 3a also in the solar cell module according to Example 2 having the slender finger electrodes 15a of the solar cells 10 arranged to extend in the direction perpendicular to the traveling direction (X) of the light reflected by the light reflective surface 21a due to the polycarbonate layer 22 having a refractive index (N = 1.6) higher than those (N = 1.5) of the glass plate 1 and an EVA layer 3a.

According to Example 2, as hereinabove described, the distance of movement of light can be increased in the direction X perpendicular to the longitudinal direction Y of the corrugated light reflective surface 21a of the metal reflective film 21 similarly to the aforementioned Example 1 by corrugating the surface of the polycarbonate layer 22 having the refractive index (N = 1.6) higher than that (N = 1.5) of the glass plate 1 while forming the metal reflective film 21 on the corrugated surface of the polycarbonate layer 22 and bonding the flat surface of the polycarbonate layer 22 to the surface portion of the glass plate 1 opposite to the incidence side and exposed between the solar cells 10, whereby it is possible to suppress such inconvenience that output characteristics are reduced due to reduction of the quantity of light incident upon the solar cells 10 also when the interval D4 between the solar cells 10 is increased by reducing the area ratio of the solar cells 10 with respect to the overall solar cell module 140 in order to reduce the cost for the solar cells 10.

Further, it has been proved that the solar cell module 140 according to Example 2 exhibited a short-circuit current lower than that of the sample 3 of the solar cell module 110 according to Example 1 having the same interval D1 (25.0 mm) between the solar cells 10 as that in Example 2. More specifically, the solar cell module 140 according to Example 2 exhibited the normalized short-circuit current of 1.092, while the sample 3 of the solar cell module 110 according to Example 1 exhibited the short-circuit current of 1.097, as shown in Table 1. This is conceivably because the quantity of light blocked by the finger electrodes 15a was increased in the solar cell module 140 according to Example 2 beyond that in the sample 3 of the solar cell module 110 according to Example 1 to reduce the quantity of light incident upon the solar cells 10.

More specifically, a virtual pitch P2 between the finger electrodes 15a is reduced as viewed from the traveling direction (along arrow A) of light incident upon the solar cells 10 in the solar cell module 140 according to Example 2, as shown in Fig. 13. Therefore, the quantity of light passing through the spaces between the finger electrodes 15a is conceivably reduced in Example 2 since regions virtually formed with the finger electrodes 15a are enlarged as viewed from the traveling direction (along arrow A) of light incident upon the solar cells 10 as compared with Example 1. Thus, the quantity of light incident upon the solar cells 10 was conceivably reduced in Example 2 as compared with Example 1.

It has been confirmed possible from these results to inhibit the quantity of light blocked by the finger electrodes 15a from increase when light reflected by the light reflective surface 21a is incident upon the solar cells 10 by arranging the slender finger electrodes 15a of the solar cells 10 in the direction (X) parallel to the traveling direction (X) of the light reflected by the light reflective surface 21a similarly to Example 1 shown in Fig. 1.

Although the present invention has been described and illustrated in detail, it is clearly understood that the same is by way of illustration and example only and is not to be taken by way of limitation, the scope of the present invention being limited only by the terms of the appended claims.

For example, while each of the solar cells is prepared by forming the non-doped amorphous silicon layers between the n-type silicon substrate and the p-type amorphous silicon layer and between the n-type silicon substrate and the n-type amorphous silicon layer respectively for constituting the solar cell module in each of the aforementioned embodiment and Example 1, the present invention is not restricted to this but is also applicable to a solar cell module employing solar cells having another structure.

While the surface of the polycarbonate layer having the refractive index (N = 1.6) higher than those (N = 1.5) of the glass plate and the EVA layer is corrugated and the metal reflective film is formed on the corrugated surface of the polycarbonate layer in each of the solar cell modules according to the aforementioned embodiment and Example 1, the present invention is not restricted to this but a layer other than the polycarbonate layer is also employable so far as the same has a refractive index higher than those of the glass plate and the EVA layer. For example, the polycarbonate layer may be replaced with a layer of an aromatic polymer such as a polystyrene layer having a refractive index of 1.6, a polyphenyl methacrylate layer having a refractive index of 1.57, a polydiallyl phthalate layer having a refractive index of 1.57, a polypentachlorophenyl methacrylate layer having a refractive index of 1.61, a poly-o-chlorostyrene layer having a refractive index of 1.61, a polyvinyl naphthalene layer having a refractive index of 1.68 or a polyvinyl carbazole layer having a refractive index of 1.68. At least two aromatic polymers may be mixed with each other in each of the aforementioned aromatic polymer layers. The refractive index of the layer having a refractive index higher than those (N = 1.5) of the glass plate and the EVA layer is preferably not more than 1.7. The reflectance can be inhibited from increase on the interface between the glass plate and this layer by setting the refractive index of the layer to not more than 1.7.

While the polycarbonate layer having the corrugated surface was formed by roll forming in the aforementioned Example 1, the present invention is not restricted to this but the polycarbonate layer having the corrugated surface may alternatively be formed by injection molding.

While the metal reflective film was formed on the corrugated surface of the polycarbonate layer by sputtering in the aforementioned Example 1, the present invention is not restricted to this but the metal reflective film may alternatively be formed on the corrugated surface of the polycarbonate layer by plating.

While Ag is employed for the metal reflective film in each of the aforementioned embodiment and Example 1, the present invention is not restricted to this but Al having high reflectance with respect to visible light may alternatively employed for the metal reflective film.

While the Ag paste was hardened under the temperature condition of 200°C for forming the finger electrodes and the bus bar electrodes in each of the aforementioned Examples 1 and 2, the present invention is not restricted to this but the temperature for hardening the Ag paste may simply be in the range of at least 150°C and not more than 250°C.

While no black film is arranged on the region, corresponding to the space between the solar cells, of the glass plate opposite to the incidence side in each of the aforementioned embodiment and Example 1, the present invention is not restricted to this but a black film may alternatively be arranged on the region, corresponding to the space between the solar cells, of the glass plate opposite to the incidence side.

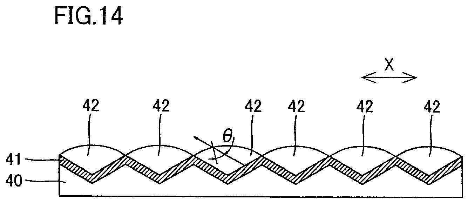

While the surface of the polycarbonate layer opposite to the metal reflective film is flattened in each of the aforementioned embodiment and Example 1, the present invention is not restricted to this but the surfaces of polycarbonate layers opposite to the metal reflective film may alternatively be prepared in the form of projecting arcs as in a first modification shown in Fig. 14. More specifically, a metal reflective film 41 having a corrugated shape reflecting a corrugated surface of a resin layer 40 is formed on the resin layer 40, as shown in Fig. 14. Polycarbonate layers 42 having surfaces, opposite to the metal reflective film 41, in the form of projecting arcs are embedded in recess portions of the metal reflective film 41 respectively. The metal reflective film 41 is an example of the "light reflective member" or the "metal layer" in the present invention, and the polycarbonate layers 42 are examples of the "second translucent member" in the present invention.

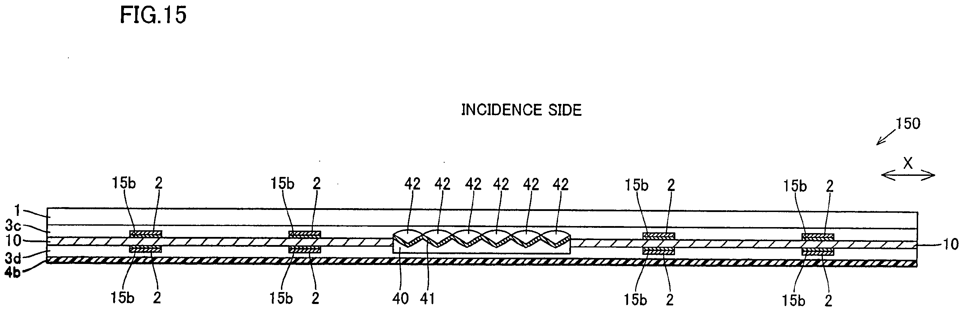

In order to apply the metal reflective film 41 and the polycarbonate layers 42 shown in Fig. 14 to a solar cell module 150, the projecting arcuate surfaces of the polycarbonate layers 42 opposite to the metal reflective film 41 are bonded to the surface of a glass plate 1 opposite to an incidence side through an EVA layer 3c for bonding the glass plate 1 and solar cells 10 to each other, as shown in Fig. 15. The EVA layer 3c is an example of the "first translucent member" or the "bonding member" in the present invention. Further, the surface of the resin layer 40 opposite to the metal reflective film 41 is bonded to a black film 4b through another EVA layer 3d for bonding the solar cells 10 and the black film 4b to each other.

In the solar cell module 150 according to the first modification shown in Figs. 14 and 15, an incident angle θ (see Fig. 14) with reference to a direction perpendicular to the interfaces between the EVA layer 3c (N = 1.5) and the polycarbonate layers 42 (N = 1.6) when light reflected by the metal reflective film 41 passes through these interfaces by employing the polycarbonate layers 42 having the projecting arcuate surfaces opposite to the metal reflective film 41 as hereinabove described, whereby the interfaces between the EVA layer 3c and the polycarbonate layers 42 can be inhibited from reflecting light toward the metal reflective film 41.

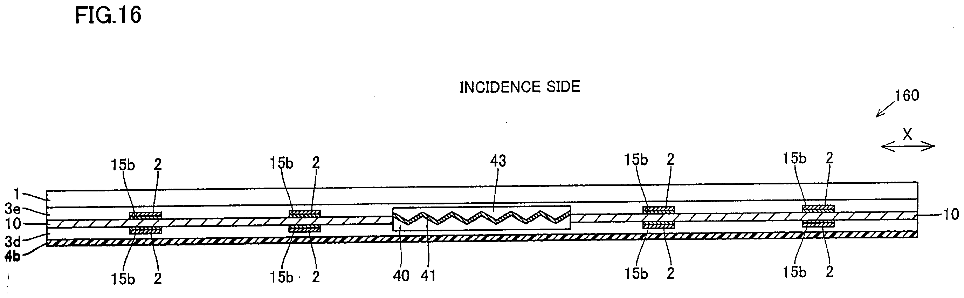

Alternatively, a polycarbonate layer 43 having a flattened surface opposite to a metal reflective film 41 may be employed in a structure similar to that of the aforementioned first modification, as in a solar cell module 160 according to a second modification shown in Fig. 16. In the solar cell module 160 according to the second modification, the flat surface of the polycarbonate layer 43 is bonded to a surface of a glass plate 1 opposite to an incidence side through an EVA layer 3e for bonding the glass plate 1 and solar cells 10 to each other. The EVA layer 3e is an example of the "first translucent member" or the "bonding member" in the present invention. According to this structure, the glass plate 1 and the polycarbonate layer 43 can be easily bonded to each other through the EVA layer 3e.

## Claims

1. A solar cell module comprising:
a first translucent member (1, 3a, 3c, 3e);
a plurality of solar cells (10) arranged on a surface of said first translucent member opposite to an incidence side at a prescribed interval; and
a light reflective member (21, 41), arranged on a region of said surface of said first translucent member opposite to said incidence side corresponding to the space between said solar cells, said light reflective member having a corrugated light reflective surface (21a) on a side of said light reflective member closer to said first translucent member, wherein
a second translucent member (22, 42, 43) having a refractive index higher than the refractive index of said first translucent member is embedded in at least recess portions of said corrugated light reflective surface of said light reflective member, so that an interface is formed between said first translucent member and said second translucent member;
each said solar cell has a plurality of slender finger electrodes arranged at a prescribed interval; the corrugations of said corrugated light reflective surface are formed to extend in a single direction (Y); and
said plurality of slender finger electrodes are arranged to extend in a direction (X) substantially perpendicular to said single direction (Y) in which the corrugations of said corrugated light reflective surface extend.

2. The solar cell module according to claim 1, wherein
said first translucent member includes at least either a glass plate (1) or an ethylene vinyl acetate layer (3a, 3c, 3e).

3. The solar cell module according to claim 2, wherein
said first translucent member includes both of said glass plate and said ethylene vinyl acetate layer.

4. The solar cell module according to claim 2, wherein
said second translucent member is composed of at least one material selected from a group consisting of polycarbonate, polystyrene, polyphenyl methacrylate, polydiallyl phthalate, polypentachlorophenyl methacrylate, poly-o-chlorostyrene, polyvinyl naphthalene and polyvinyl carbazole.

5. The solar cell module according to claim 4, wherein
said second translucent member is composed of polycarbonate.

6. The solar cell module according to claim 1, wherein
said first translucent member includes either a glass plate (1) or an ethylene vinyl acetate layer (3a, 3c, 3e) having a refractive index of 1.5, and
said second translucent member has a refractive index higher than 1.5 and not more than 1.7.

7. The solar cell module according to claim 1, wherein
said corrugated light reflective surface of said light reflective member is formed to be inclined by a prescribed angle with respect to a direction parallel to said surface of said first translucent member and to extend in a direction substantially perpendicular to the direction of arrangement of said plurality of solar cells arranged at said prescribed interval.

8. The solar cell module according to claim 1, wherein
said second translucent member (22, 43) is embedded in said recess portions of said corrugated light reflective surface of said light reflective member and formed to cover projecting portions of said corrugated light reflective surface of said light reflective member, and
a surface of said second translucent member opposite to said light reflective member is substantially flat.

9. The solar cell module according to claim 8, wherein
said first translucent member includes a face-side member (1) and a bonding member (3e) for bonding said face-side member and said second translucent member (43) to each other,
said face-side member and said bonding member have substantially identical refractive indices, and
said substantially flat surface of said second translucent member is bonded to said face-side member through said bonding member.

10. The solar cell module according to claim 1, wherein
a surface of said second translucent member (42) opposite to said light reflective member is in the form of a projecting arc.

11. The solar cell module according to claim 10, wherein
said first translucent member includes a face-side member (1) and a bonding member (3c) for bonding said face-side member and said second translucent member to each other,
said face-side member and said bonding member have substantially identical refractive indices, and
said surface of said second translucent member in the form of a projecting arc is bonded to said face-side member through said bonding member.

12. The solar cell module according to claim 11, wherein
said face-side member includes a glass plate (1), and
said bonding member includes an ethylene vinyl acetate layer (3c).

13. The solar cell module according to claim 11, wherein
said bonding member also has a function of bonding said face-side member and said solar cells to each other.

14. The solar cell module according to claim 1, wherein
said second translucent member (42) includes a plurality of second translucent members embedded in respective said recess portions of said corrugated light reflective surface of said light reflective member.

15. The solar cell module according to claim 14, wherein
a surface of each said second translucent member opposite to said light reflecting member is in the form of a projecting arc.

16. The solar cell module according to claim 1, wherein
a surface of said second translucent member opposite to said first translucent member is corrugated, and
a metal layer (21, 41) constituting said light reflective member is formed on said corrugated surface of said second translucent member.

17. The solar cell module according to claim 16, wherein
said metal layer constituting said light reflective member is formed to have a corrugated shape reflecting said corrugated surface of said second translucent member.

## Patentansprüche

1. Solarzellenmodul, umfassend:
ein erstes lichtdurchlässiges Element (1, 3a, 3c, 3e);
eine Vielzahl von Solarzellen (10), die auf einer Oberfläche des ersten lichtdurchlässigen Elements, die einer Lichteinfallsseite gegenüberliegt, in einem vorgeschriebenen Abstand angeordnet sind; und
ein lichtreflektierendes Element (21, 41), das auf einer Region der Oberfläche des ersten lichtdurchlässigen Elements, die der Lichteinfallsseite gegenüberliegt, die dem Raum zwischen den Solarzellen entspricht, angeordnet ist, wobei das lichtreflektierende Element eine gewellte lichtreflektierende Oberfläche (21a) auf einer dem ersten lichtdurchlässigen Element näheren Seite des lichtreflektierenden Elements aufweist, wobei
ein zweites lichtdurchlässiges Element (22, 42, 43), das einen Brechungsindex aufweist, der höher als der Brechungsindex des ersten lichtdurchlässigen Elements ist, in zumindest Vertiefungsabschnitten der gewellten lichtreflektierenden Oberfläche des lichtreflektierenden Elements eingebettet ist, sodass eine Grenzfläche zwischen dem ersten lichtdurchlässigen Element und dem zweiten lichtdurchlässigen Element ausgebildet ist;
wobei jede Solarzelle eine Vielzahl von schmalen Fingerelektroden aufweist, die in einem vorgeschriebenen Abstand angeordnet sind;
wobei die Wellungen der gewellten lichtreflektierenden Oberfläche so ausgebildet sind, dass sie sich in eine einzige Richtung (Y) erstrecken; und
wobei die Vielzahl von schmalen Fingerelektroden so angeordnet ist, dass sie sich in eine Richtung (X) erstreckt, die im Wesentlichen senkrecht zur einzigen Richtung (Y) ist, in die sich die Wellungen der gewellten lichtreflektierenden Oberfläche erstrecken.

2. Solarzellenmodul gemäß Anspruch 1, wobei
das erste lichtdurchlässige Element zumindest entweder eine Glasplatte (1) oder eine Ethylenvinylacetatschicht (3a, 3c, 3e) umfasst.

3. Solarzellenmodul gemäß Anspruch 2, wobei
das erste lichtdurchlässige Element sowohl die Glasplatte als auch die Ethylenvinylacetatschicht umfasst.

4. Solarzellenmodul gemäß Anspruch 2, wobei
das zweite lichtdurchlässige Element aus mindestens einem Material besteht, das aus der aus Polykarbonat, Polystyren, Polyphenyl-Methacrylat, Polydiallyl-Phthalat, Polypentachlorphenyl-Methacrylat, Poly-o-Chlorstyrol, Polyvinyl-Naphtalen und Polyvinyl-Carbazol bestehenden Gruppe ausgewählt ist.

5. Solarzellenmodul gemäß Anspruch 4, wobei
das zweite lichtdurchlässige Element aus Polykarbonat besteht.

6. Solarzellenmodul gemäß Anspruch 1, wobei
das erste lichtdurchlässige Element entweder eine Glasplatte (1) oder eine Ethylenvinylacetatschicht (3a, 3c, 3e) umfasst, die einen Brechungsindex von 1,5 aufweist, und
das zweite lichtdurchlässige Element einen Brechungsindex aufweist, der höher als 1,5 und nicht mehr als 1,7 ist.

7. Solarzellenmodul gemäß Anspruch 1, wobei
die gewellte lichtreflektierende Oberfläche des lichtreflektierenden Elements so ausgebildet ist, dass sie um einen vorgeschriebenen Winkel mit Bezug auf eine Richtung, die zur Oberfläche des ersten lichtdurchlässigen Elements parallel ist, geneigt ist, und sich in eine zur Richtung der Anordnung der Vielzahl von den im vorgeschriebenen Abstand angeordneten Solarzellen im Wesentlichen senkrechten Richtung erstreckt.

8. Solarzellenmodul gemäß Anspruch 1, wobei
das zweite lichtdurchlässige Element (22, 43) in den Vertiefungsabschnitten der gewellten lichtreflektierenden Oberfläche des lichtreflektierenden Elements eingebettet und derart ausgebildet ist, dass es vorstehende Abschnitte der gewellten lichtreflektierenden Oberfläche des lichtreflektierenden Elements abdeckt, und
eine Oberfläche des dem lichtreflektierenden Element gegenüberliegenden, zweiten lichtdurchlässigen Elements im Wesentlichen flach ist.

9. Solarzellenmodul gemäß Anspruch 8, wobei
das erste lichtdurchlässige Element ein flächenseitiges Element (1) und ein Bonding-Element (3e) zum Bonden des flächenseitigen Elements und des zweiten lichtdurchlässigen Elements (43) aneinander umfasst,
das flächenseitige Element und das Bonding-Element im Wesentlichen identische Brechungsindexe aufweisen, und
die im Wesentlichen flache Oberfläche des zweiten lichtdurchlässigen Elements mit dem flächenseitigen Element durch das Bonding-Element haftschlüssig verbunden ist.

10. Solarzellenmodul gemäß Anspruch 1, wobei
eine Oberfläche des dem lichtreflektierenden Element gegenüberliegenden, zweiten lichtdurchlässigen Elements (42) in der Form eines vorstehenden Bogens ist.

11. Solarzellenmodul gemäß Anspruch 10, wobei
das erste lichtdurchlässige Element ein flächenseitiges Element (1) und ein Bonding-Element (3c) zum Bonden des flächenseitigen Elements und des zweiten lichtdurchlässigen Elements aneinander umfasst,
das flächenseitige Element und das Bonding-Element im Wesentlichen identische Brechungsindexe aufweisen, und
die Oberfläche des zweiten lichtdurchlässigen Elements in der Form eines vorstehenden Bogens durch das Bonding-Element mit dem flächenseitigen Element haftschlüssig verbunden ist.

12. Solarzellenmodul gemäß Anspruch 11, wobei
das flächenseitige Element eine Glasplatte (1) umfasst, und
das Bonding-Element eine Etylenvinylacetatschicht (3c) umfasst.

13. Solarzellenmodul gemäß Anspruch 11, wobei
das Bonding-Element auch eine Funktion des Bondens des flächenseitigen Elements und der Solarzellen aneinander aufweist.

14. Solarzellenmodul gemäß Anspruch 1, wobei
das zweite lichtdurchlässige Element (42) eine Vielzahl von zweiten lichtdurchlässigen Elementen umfasst, die in den jeweiligen Vertiefungsabschnitten der gewellten lichtreflektierenden Oberfläche des lichtreflektierenden Elements eingebettet sind.

15. Solarzellenmodul gemäß Anspruch 14, wobei
eine Oberfläche von jedem zweiten lichtdurchlässigen Element, das dem lichtreflektierenden Element gegenüberliegt, in der Form eines vorstehenden Bogens ist.

16. Solarzellenmodul gemäß Anspruch 1, wobei
eine Oberfläche des dem ersten lichtdurchlässigen Element gegenüberliegenden, zweiten lichtdurchlässigen Elements gewellt ist, und
eine Metallschicht (21, 41), die das lichtreflektierende Element bildet, auf der gewellten Oberfläche des zweiten lichtdurchlässigen Elements ausgebildet ist.

17. Solarzellenmodul gemäß Anspruch 16, wobei
die Metallschicht, die das lichtreflektierende Element bildet, so ausgebildet ist, dass sie eine gewellte Form aufweist, welche die gewellte Oberfläche des zweiten lichtdurchlässigen Elements reflektiert.

## Revendications

1. Module de cellules solaires comprenant :
un premier élément translucide (1, 3a, 3c, 3e) ;
une pluralité de cellules solaires (10) agencées sur une surface dudit premier élément translucide opposée à un côté d'incidence à un intervalle prescrit ; et
un élément réfléchissant la lumière (21, 41), agencé sur une région de ladite surface dudit premier élément translucide opposée audit côté d'incidence correspondant à l'espace entre lesdites cellules solaires, ledit élément réfléchissant la lumière ayant une surface réfléchissant la lumière ondulée (21a) d'un côté dudit élément réfléchissant la lumière plus proche dudit premier élément translucide, dans lequel
un deuxième élément translucide (22, 42, 43) ayant un indice de réfraction supérieur à l'indice de réfraction dudit premier élément translucide est intégré au moins dans les parties en retrait de ladite surface réfléchissant la lumière ondulée dudit élément réfléchissant la lumière, de sorte qu'une interface est formée entre ledit premier élément translucide et ledit deuxième élément translucide ;
chaque dite cellule solaire comporte une pluralité d'électrodes doigts minces agencées à un intervalle prescrit ;
les ondulations de ladite surface réfléchissant la lumière ondulée sont formées de manière à s'étendre dans une seule direction (Y) ; et
ladite pluralité d'électrodes doigts minces sont agencées de manière à s'étendre dans une direction (X) sensiblement perpendiculaire à ladite direction (Y) unique dans laquelle les ondulations de ladite surface réfléchissant la lumière ondulée s'étendent.

2. Module de cellules solaires selon la revendication 1, dans lequel
ledit premier élément translucide comprend au moins soit une plaque de verre (1), soit une couche d'éthylène acétate de vinyle (3a, 3c, 3e).

3. Module de cellules solaires selon la revendication 2, dans lequel
ledit premier élément translucide comprend à la fois ladite plaque de verre et ladite couche d'éthylène acétate de vinyle.

4. Module de cellules solaires selon la revendication 2, dans lequel
ledit deuxième élément translucide est composé d'au moins un matériau sélectionné dans un groupe consistant en le polycarbonate, le polystyrène, le méthacrylate de polyphényle, le polydiallyl phtalate, le méthacrylate de polypentachlorophényle, le poly-o-chlorostyrène, le naphthalène de polyvinyle et le carbazole de polyvinyle.

5. Module de cellules solaires selon la revendication 4, dans lequel
ledit deuxième élément translucide est composé de polycarbonate.

6. Module de cellules solaires selon la revendication 1, dans lequel
ledit premier élément translucide comprend soit une plaque de verre (1), soit une couche d'éthylène acétate de vinyle (3a, 3c, 3e) ayant un indice de réfraction de 1,5, et
ledit deuxième élément translucide a un indice de réfraction supérieur à 1,5 et inférieur ou égal à 1,7.

7. Module de cellules solaires selon la revendication 1, dans lequel
ladite surface réfléchissant la lumière ondulée dudit élément réfléchissant la lumière est formée de manière à être inclinée d'un angle prescrit par rapport à une direction parallèle à ladite surface dudit premier élément translucide et à s'étendre dans une direction sensiblement perpendiculaire à la direction d'agencement de ladite pluralité de cellules solaires agencées audit intervalle prescrit.

8. Module de cellules solaires selon la revendication 1, dans lequel
ledit deuxième élément translucide (22, 43) est intégré dans lesdites parties en retrait de ladite surface réfléchissant la lumière ondulée dudit élément réfléchissant la lumière et formé de manière à recouvrir les parties saillantes de ladite surface réfléchissant la lumière ondulée dudit élément réfléchissant la lumière, et
une surface dudit deuxième élément translucide opposée audit élément réfléchissant la lumière est sensiblement plate.

9. Module de cellules solaires selon la revendication 8, dans lequel
ledit premier élément translucide comprend un élément côté face (1) et un élément de liaison (3e) pour lier ledit élément côté face et ledit deuxième élément translucide (43) l'un à l'autre,
ledit élément côté face et ledit élément de liaison ont des indices de réfraction sensiblement identiques, et
ladite surface sensiblement plate dudit deuxième élément translucide est liée audit élément côté face par l'intermédiaire dudit élément de liaison.

10. Module de cellules solaires selon la revendication 1, dans lequel
une surface dudit deuxième élément translucide (42) opposée audit élément réfléchissant la lumière a la forme d'un arc saillant.

11. Module de cellules solaires selon la revendication 10, dans lequel
ledit premier élément translucide comprend un élément côté face (1) et un élément de liaison (3c) pour lier ledit élément côté face et ledit deuxième élément translucide l'un à l'autre,
ledit élément côté face et ledit élément de liaison ont des indices de réfraction sensiblement identiques, et
ladite surface dudit deuxième élément translucide sous la forme d'un arc saillant est liée audit élément côté face par l'intermédiaire dudit élément de liaison.

12. Module de cellules solaires selon la revendication 11, dans lequel
ledit élément côté face comprend une plaque de verre (1), et
ledit élément de liaison comprend une couche d'éthylène acétate de vinyle (3c).

13. Module de cellules solaires selon la revendication 11, dans lequel
ledit élément de liaison a également pour fonction de lier ledit élément côté face et lesdites cellules solaires les uns aux autres.

14. Module de cellules solaires selon la revendication 1, dans lequel
ledit deuxième élément translucide (42) comprend une pluralité de deuxièmes éléments translucides intégrés dans lesdites parties en retrait respectives de ladite surface réfléchissant la lumière ondulée dudit élément réfléchissant la lumière.

15. Module de cellules solaires selon la revendication 14, dans lequel
une surface de chaque dit deuxième élément translucide opposée audit élément de réflexion de lumière a la forme d'un arc saillant.

16. Module de cellules solaires selon la revendication 1, dans lequel
une surface dudit deuxième élément translucide opposée audit premier élément translucide est ondulée, et
une couche métallique (21, 41) constituant ledit élément réfléchissant la lumière est formée sur ladite surface ondulée dudit deuxième élément translucide.

17. Module de cellules solaires selon la revendication 16, dans lequel
ladite couche métallique constituant ledit élément réfléchissant la lumière est formée de manière à avoir une forme ondulée reflétant ladite surface ondulée dudit deuxième élément translucide.
